# EUROPEAN PATENT APPLICATION

(11) **EP 4 312 099 A1**
(43) Date of publication of application: **31.01.2024**
(21) Application number: 22187277.3
(22) Date of filing: 27.07.2022
(51) Int. Cl.: G05B 23/02

(54) **METHOD OF TRAINING A MACHINE LEARNING MODEL FOR DETECTING ONE OR MORE FAULTS**

(71) Applicant: Siemens Aktiengesellschaft, 80333 München (DE)
(72) Inventor: Al Hage Ali, Ali, 91052 Erlangen (DE); Khalil, Mohamed, 81379 München (DE); Malik, Vincent, 80636 München (DE); Wolf Pozzo, Christian Andreas, 90513 Zirndorf (DE)
(74) Representative: Siemens Patent Attorneys

(57) **Abstract**

The current disclosure describes a method of training a machine learning model for detecting one or more faults associated with at least one component of a drive train. The method comprises providing a simulation model associated with the at least one component of the drive train, configuring the simulation model using a predefined configuration for generating training data for the machine learning model, generating the training data using the configured simulation model, and training the machine learning model using the generated training data for detecting the health of at least one component of the drive train. The simulation model is configured to simulate a plurality of conditions based on the predefined configuration, for generating training data which comprises a plurality of datasets, wherein at least one dataset from the plurality of datasets is associated with a corresponding fault of the at least one component of the drive train.

## Description

### Background:

The current disclosure relates to condition monitoring and more particularly, relates to condition monitoring of a drive train using machine learning models. Conventionally, to detect faults on motor and related drive train applications or loads e.g. pumps or fans, machine learning models need to be trained with complex measurements and considerable expert knowledge. This requires considerable amount of time and effort prior to deployment of the trained model.

### Description:

The current disclosure relates to condition monitoring of a drive train. Machine learning models are often used to detection of condition of the components of the drive train based on various sensor data associated with the drive train components. However, the use of machine learning approach requires considerable volume of measured data for the training the machine learning models.

This can be particularly challenging as accumulating data, especially for critical defects on applications, may not be feasible due to e.g. safety reasons, or may be very costly. Accordingly, the transfer of such models is possible only for similar applications (i.e. same type and same size). To transfer the machine learning model to different application and achieve same accuracy, a time-consuming retraining of the exiting model would be required. Moreover, to use the machine learning model in the specific configuration the data in the reference condition (in the "good" healthy status without failure) of the drive train are required. This is often difficult or not possible for the running application in the brownfield. As such data may not be available if the application experienced a failure at the time of the initialization of machine learning model. Accordingly, there is a need for a method and device which allows for training of machine learning models without considerable collection of measurement data.

Accordingly, the current disclosure describes a method of training a machine learning model for detecting one or more faults associated with at least one component of a drive train. The method comprises providing a simulation model associated with the at least one component of the drive train, the simulation model for simulating an operation of at least one component of the drive train, configuring the simulation model using a predefined configuration for generating training data for the machine learning model, generating the training data using the configured simulation model, and training the machine learning model using the generated training data for detecting the health of at least one component of the drive train. The trained machine learning model is configured to receive sensor data associated with the at least one component of the drive train and detect the one or more faults associated the at least one component of the drive train based on the received sensor data. The simulation model is configured to simulate a plurality of conditions based on the predefined configuration. The training data comprises a plurality of datasets, wherein at least one dataset from the plurality of datasets is associated with a corresponding fault of the at least one component of the drive train.

Accordingly, the current disclosure discloses utilization of synthetic labeled data from the simulation model, for training the machine learning model. Accordingly, this allows for easy and quick training of machine learning models for condition monitoring and fault detection without extensive collection of measurement data associated with various conditions, faults and configurations of drive train. Accordingly, the machine learning model may be quickly trained and deployed using the simulation model associated with the components of the drive train. In an example, the drive train includes a motor connected to a load using a gear box.

Additionally, the generated training data may cover a plurality of fault scenarios e.g. misalignment, cavitation, unbalance, etc. The simulation model may be configured to simulate a plurality of critical faults associated with the application of interest. Different fault severities (tolerable, mild, severe, etc.) can be simulated at different operating conditions (speeds, loads, etc.). Additionally, different drive train configurations can be simulated. For example, various foundations can be used to mount the drive train on, different types of couplings. The simulation model subcomponents can be parameterized to cover different configurations and sizes.

In an embodiment, the predefined configuration includes a plurality of parameters associated with the at least one component of the drive train, each parameter further comprising a plurality of values associated with the corresponding parameter. Accordingly, the simulation is configured to simulate a plurality of conditions which are specified based on the values of the plurality of parameters. Accordingly, the training data generated covers a comprehensive set of scenarios associated with the at least one component of the drive train.

In an embodiment, the plurality of datasets includes at least another dataset, wherein the at least another dataset is associated with a normal operation of the at least one component of the drive train. Accordingly, the machine learning model is trained using datasets reflective of fault condition and healthy condition. In an embodiment, the sensor data includes vibration data associated with the at least one component of the drive train. Accordingly, the machine learning model is configured to receive vibration data from one or more vibration sensors and detect the condition of the at least one component on the basis of the vibration data.

In an embodiment, the plurality of parameters includes a first set of parameters is associated with one or more faults associated with the at least one component of the drive train and a second set of parameters associated with operation of the at least one component of the drive train. Accordingly, the simulation model is configured to simulate a plurality of fault conditions in combination with a plurality of drive train configuration.

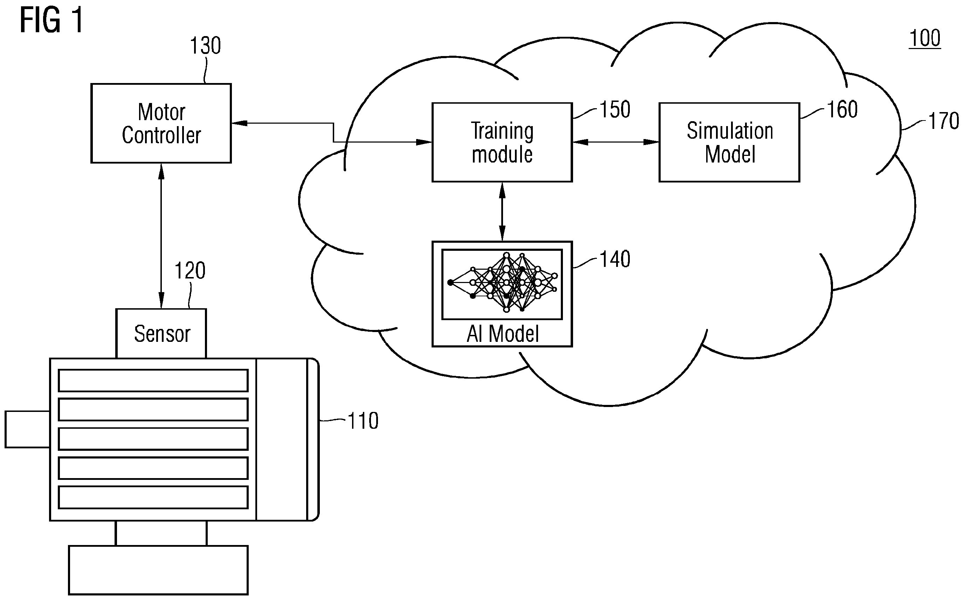

In another aspect, the current disclosure describes a computing device for training a machine learning model for detecting one or more faults associated with at least one component of a drive train. The computing device comprises one or more processors connected to a memory module. The one or more processors are configured to configure the simulation model using a predefined configuration, for generating training data for the machine learning model, wherein the simulation model is configured to simulate operation of at least one component of the drive train in a plurality of conditions based on the predefined configuration, generate the training data using the configured simulation model, wherein the training data comprises a plurality of datasets, wherein at least one dataset from the plurality of datasets is associated with a corresponding fault of the at least one component of the drive train; and train the machine learning model using the generated training data for detecting the health of at least one component of the drive train; wherein the trained machine learning model is configured to receive sensor data associated with the at least one component of the drive train and detect the one or more faults associated the at least one component of the drive train based on the received sensor data. Similarly, the current disclosure describes a non transitory storage medium containing a plurality of instructions, which when executed on one or more processors, cause the one or more processors to configure the simulation model using a predefined configuration, for generating training data for the machine learning model, wherein the simulation model is configured to simulate operation of at least one component of the drive train in a plurality of conditions based on the predefined configuration, generate the training data using the configured simulation model, wherein the training data comprises a plurality of datasets, wherein at least one dataset from the plurality of datasets is associated with a corresponding fault of the at least one component of the drive train; and train the machine learning model using the generated training data for detecting the health of at least one component of the drive train; wherein the trained machine learning model is configured to receive sensor data associated with the at least one component of the drive train and detect the one or more faults associated the at least one component of the drive train based on the received sensor data. The advantages of the method are applicable to the device and the non transitory storage medium. These aspects are further explained in relation to figures 1-3.
Figure 1 illustrates a section of the industrial facility comprising a motor of a drive train, connected to a motor controller;
Figure 2 illustrates a method of training a machine learning model for detecting one or more faults associated with at least one component of a drive train; and
Figure 3 illustrates a computing device for training a machine learning model for detecting one or more faults associated with at least one component of a drive train.

Figure 1 illustrates a section 100 of the industrial facility comprising a motor 110 of a drive train, connected to a motor controller 130. Industrial facility herein refers to any environment where one or more industrial processes such as manufacturing, refining, smelting, assembly of equipment, etc., may take place. Examples of industrial facility includes process plants, oil refineries, automobile factories, etc. The drive train includes a mechanical load connected to the motor 110 using a gear box. The mechanical load is associated with a process in the industrial facility and may include fans, pumps, etc.

The motor controller 130 is capable of monitoring and controlling the motor 110. Accordingly, the motor controller 130 is connected to plurality of sensors mounted on the motor 110. The plurality of sensors (for example sensor 120 as shown in figure 1) are for measuring a plurality of parameters associated with the motor 110. For example, the plurality of sensors include a magnetic field sensor, a vibration sensor, an acoustic sensor, a temperature sensor, etc. The magnetic field sensor may measure magnetic field strength along one or more axes of the motor 110. The vibration sensor may measure vibrations along the one or more axes of the motor 110. The temperature sensor may measure a temperature of an area proximal to the motor 110. The acoustic sensor may measure sound around the motor 110, particularly the sound arising from around the drive side of the motor 110. Accordingly, the motor controller 130 is configured to receive sensor data from the plurality of sensors and determine a condition of the motor based on the sensor data.

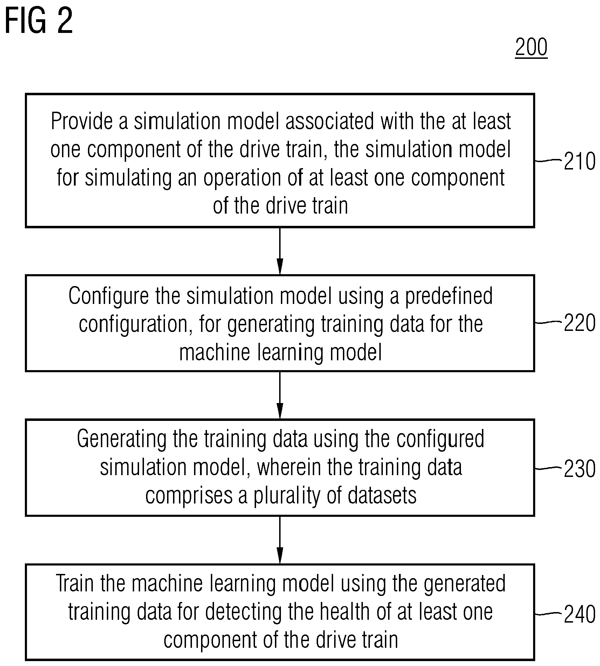

Accordingly, in this regard, the motor controller 130 includes a trained machine learning model for determine the health or condition of the motor. The motor controller 130 is connected to a training module 150 for receiving the trained machine learning model. The training module 150 may be located on an industrial cloud platform 170 outside the industrial facility. The training module 150 is connected to a simulation model 160 for training the machine learning model 140 which is after training provided to the motor controller 130. Using the simulation model 160 of the motor 110, the machine learning model 140 is trained by the training module 150. This allows for training of the machine learning model 140 without significant volume of real motor data, thereby resulting in easy and fast deployment of the machine learning model. This is further explained in reference to figure 2.

Figure 2 illustrates a method 200 of training a machine learning model 140 for detecting one or more faults associated with at least one component of a drive train. In an example, the method 200 is realized by the training module 150. While the method 200 may be applied for any component in the drive train, the method 200 is explained using the motor 110.

At step 210, a simulation model 160 associated with the at least one component of the drive train is provided. The simulation model 160 for simulating an operation of at least one component of the drive train. The simulation model 160 is based on the configuration of the drive train in the industrial facility. Accordingly, the simulation model 160 is based on the configuration of the load connected, the configuration of the motor and the configuration of the gear box.

Then, at step 220, the training module configures the simulation model using a predefined configuration for generating training data for the machine learning model. The simulation model is configured to simulate a plurality of conditions based on the predefined configuration. The predefined configuration includes a plurality of parameters associated with the at least one component of the drive train, each parameter further comprising a plurality of values associated with the corresponding parameter. For example, the plurality of parameters includes a first set of parameters is associated with one or more faults associated with the at least one component of the drive train and a second set of parameters associated with operation of the at least one component of the drive train.

The first set of parameters may indicate if a particular fault is to be simulated and if so the degree to which the fault may be simulated. For example, the first set of parameters includes faults such as misalignment, cavitation, impeller fault, etc. Each parameter from the first set of parameters further includes one or more values indicative of a degree of the corresponding fault. For example, a misalignment parameter may includes values 0, .1, .2, etc. The value 0 indicates that the misalignment fault is absent. The values above 0 are indicative of the degree of the misalignment fault.

The second set of parameters may indicate the conditions of operation associated with the at least one component. For example, the second set of parameters may include different parameters associated with the load connected to the motor, such as weight of the load, diameter of the load, rotations per minute associated of the load, curve characteristics of the load, etc. Additionally, each parameter includes one or more values. For example, the weight of the load may include 25 kilograms, 30 kilograms, etc.

Then, at step 230 the training module generates the training data using the configured simulation model. The simulation model generates the training data by simulating the various physical parameters which may be read by the one or more sensors. For example, the simulation model may simulate vibration, electromagnetic field/flux, acoustic signals, temperature, etc. Particularly, the simulation model simulates the above mentioned physical parameters at the locations where the sensors may be mounted on the at least one component of the drive train. The simulation using the simulation model is performed using the first and second set of parameters. The simulation model simulates the operation of the at least one component in various conditions based on the combination of the values and parameters from the first and second set of parameters. For example, the simulation model generates vibration data for a motor with a 20kg load and misalignment fault of .1 value, a motor with 30kg load with no misalignment fault, and other such combinations based on first and second set of parameters.

The training data generated by the simulation model comprises a plurality of datasets, wherein at least one dataset from the plurality of datasets is associated with a corresponding fault of the at least one component of the drive train. As mentioned above, the simulation model generates the training data by simulating the operation of the component of the drive train (particularly the physical parameters such as vibration, electromagnetic flux, temperature, etc.) based on a combination of the first and second set of parameters. For each combination of the first and second set of parameters, a corresponding data set is generated via the simulation. The corresponding data set is labelled with the faults present in the simulation according to the first set of parameters. Accordingly, the training data generated is labelled with the corresponding faults from the first set of parameters.

In an example, the plurality of datasets includes at least another dataset, wherein the at least another dataset is associated with a normal operation of the at least one component of the drive train. Accordingly, the simulation model is also used to simulate operation of the at least one component without any fault. Accordingly, all the first set of parameters are at simulated with value 0.

Then at step 240, the training module trains the machine learning model using the generated training data for detecting the health of at least one component of the drive train. The machine learning model is trained using the different datasets with the labels for detection of the faults in the at least one component of the drive train.

Accordingly, the trained machine learning model is configured to receive sensor data associated with the at least one component of the drive train and detect the one or more faults associated the at least one component of the drive train based on the received sensor data.

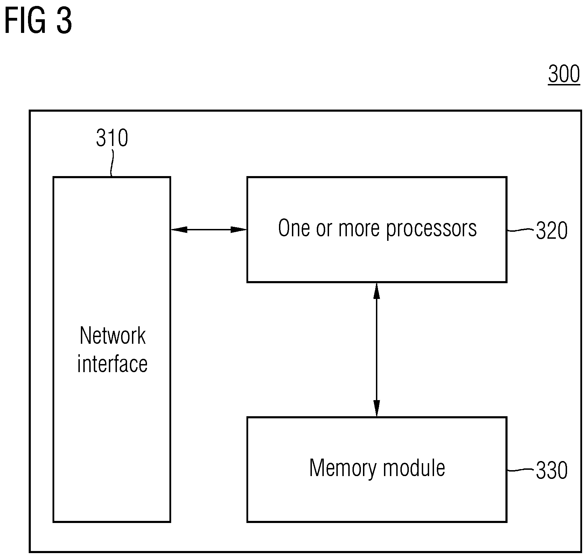

It may be noted that while the above mentioned method is explained in reference to the training module 150, the above method may be realized using one or more devices or via one or more software modules. Accordingly, the current disclosure describes a computing device 300 which is further described in relation to figure 3.

Figure 3 discloses a computing device 300 for training a machine learning model 140 for detecting one or more faults associated with at least one component of a drive train. The computing device 300 comprises one or more processors 320 connected to a memory module 330. The computing device 300 further comprises a network interface 310 for communicating with the industrial devices in the industrial facility. The memory module 330 (also referred to as non transitory storage medium 330) includes a plurality of instructions which when executed by the one or more processors, cause the one or more processors 320 to configure the simulation model using a predefined configuration, for generating training data for the machine learning model, generate the training data using the configured simulation model, and train the machine learning model using the generated training data for detecting the health of at least one component of the drive train.

For the purpose of this description, a computer-usable or computer-readable non-transitory storage medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processing units and program code for implementing each aspect of the technology can be centralized or distributed (or a combination thereof) as known to those skilled in the art.

While the current disclosure is described with references to few industrial devices, a plurality of industrial devices may be utilized in the context of the current disclosure. While the present disclosure has been described in detail with reference to certain embodiments, it should be appreciated that the present disclosure is not limited to those embodiments.

In view of the present disclosure, many modifications and variations would be present themselves, to those skilled in the art without departing from the scope of the various embodiments of the present disclosure, as described herein. The scope of the present disclosure is, therefore, indicated by the following claims rather than by the foregoing description. All changes, modifications, and variations coming within the meaning and range of equivalency of the claims are to be considered within their scope. All advantageous embodiments claimed in method claims may also be apply to device/non-transitory storage medium claims.

## Claims

1. A method of training a machine learning model for detecting one or more faults associated with at least one component of a drive train, the method comprising:
a. providing a simulation model associated with the at least one component of the drive train, the simulation model for simulating an operation of at least one component of the drive train;
b. configuring the simulation model using a predefined configuration, for generating training data for the machine learning model, wherein the simulation model is configured to simulate a plurality of conditions based on the predefined configuration,
c. generating the training data using the configured simulation model, wherein the training data comprises a plurality of datasets, wherein at least one dataset from the plurality of datasets is associated with a corresponding fault of the at least one component of the drive train;
d. training the machine learning model using the generated training data for detecting the health of at least one component of the drive train;
wherein the trained machine learning model is configured to receive sensor data associated with the at least one component of the drive train and detect the one or more faults associated the at least one component of the drive train based on the received sensor data.

2. The method as claimed in claim 1, wherein the predefined configuration includes a plurality of parameters associated with the at least one component of the drive train, each parameter further comprising a plurality of values associated with the corresponding parameter.

3. The method as claimed in claim 1, wherein the plurality of datasets includes at least another dataset, wherein the at least another dataset is associated with a normal operation of the at least one component of the drive train.

4. The method as claimed in claim 1, wherein the sensor data includes vibration data associated with the at least one component of the drive train.

5. The method as claimed in claim 1, wherein the drive train includes a motor connected to a load using a gear box.

6. The method as claimed in claim 2, wherein the plurality of parameters includes a first set of parameters is associated with one or more faults associated with the at least one component of the drive train and a second set of parameters associated with operation of the at least one component of the drive train.

7. A computing device for training a machine learning model for detecting one or more faults associated with at least one component of a drive train, the computing device comprising:
a. One or more processors connected to a memory module, the one or more processors configured to:
i. configure the simulation model using a predefined configuration, for generating training data for the machine learning model, wherein the simulation model is configured to simulate operation of at least one component of the drive train in a plurality of conditions based on the predefined configuration,
ii. generate the training data using the configured simulation model, wherein the training data comprises a plurality of datasets, wherein at least one dataset from the plurality of datasets is associated with a corresponding fault of the at least one component of the drive train;
iii. train the machine learning model using the generated training data for detecting the health of at least one component of the drive train;
wherein the trained machine learning model is configured to receive sensor data associated with the at least one component of the drive train and detect the one or more faults associated the at least one component of the drive train based on the received sensor data.

8. A non transitory storage medium containing a plurality of instructions, which when executed on one or more processors, cause the one or more processors to:
a. configure the simulation model using a predefined configuration, for generating training data for the machine learning model, wherein the simulation model is configured to simulate operation of at least one component of the drive train in a plurality of conditions based on the predefined configuration,
b. generate the training data using the configured simulation model, wherein the training data comprises a plurality of datasets, wherein at least one dataset from the plurality of datasets is associated with a corresponding fault of the at least one component of the drive train;
c. train the machine learning model using the generated training data for detecting the health of at least one component of the drive train;
wherein the trained machine learning model is configured to receive sensor data associated with the at least one component of the drive train and detect the one or more faults associated the at least one component of the drive train based on the received sensor data.
